## Europäisches Patentamt

**European Patent Office**

**Office européen des brevets**

(19)

(11) Numéro de publication : **0 401 906 B1**

(12)

# FASCICULE DE BREVET EUROPEEN

(45) Date de publication du fascicule du brevet :
07.04.93 Bulletin 93/14

(51) Int. Cl.⁵ : **H03H 7/21**

(21) Numéro de dépôt : **90201386.1**

(22) Date de dépôt : **31.05.90**

---

(54) **Circuit déphaseur amélioré.**

---

(30) Priorité : **06.06.89 FR 8907441**

(43) Date de publication de la demande :
**12.12.90 Bulletin 90/50**

(45) Mention de la délivrance du brevet :
**07.04.93 Bulletin 93/14**

(84) Etats contractants désignés :
**DE FR GB IT**

(56) Documents cités :
**US-A- 3 621 406**

(73) Titulaire : **LABORATOIRES D'ELECTRONIQUE PHILIPS**
**1, Avenue Descartes**
**F-94450 Limeil-Brévannes (FR)**
(84) **FR**
Titulaire : **N.V. Philips' Gloeilampenfabrieken**
**Groenewoudseweg 1**
**NL-5621 BA Eindhoven (NL)**
(84) **DE GB IT**

(72) Inventeur : **Philippe, Pascal**
**Societé Civile S.P.I.D., 209 rue de l'Université**
**F-75007 Paris (FR)**

(74) Mandataire : **Caron, Jean et al**
**Société Civile S.P.I.D. 156, Boulevard Haussmann**
**F-75008 Paris (FR)**

---

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

Jouve, 18, rue Saint-Denis, 75001 PARIS

## Description

La présente invention concerne un circuit déphaseur, muni d'une première et d'une seconde borne d'entrée destinées à recevoir deux signaux en opposition de phase, et d'une première et d'une seconde borne de sortie destinées à fournir deux signaux déphasés par rapport aux signaux d'entrée, circuit comportant une première combinaison en série d'une résistance et d'une capacité connectées entre les bornes d'entrée, première combinaison dans laquelle la résistance est connectée à la première borne d'entrée et le point de jonction entre la résistance et la capacité est relié à la première borne de sortie, et une seconde combinaison en série d'une résistance et d'une capacité connectées entre les bornes d'entrée, seconde combinaison dans laquelle la résistance est connectée à la seconde borne d'entrée et le point de jonction entre la résistance et la capacité est relié à la seconde borne de sortie.

Les domaines d'application d'un tel circuit sont variés en électronique: on peut mentionner notamment les émetteurs/récepteurs de radio dits BLU, les modulateurs de phase à quatre états ou multiples de quatre, les antennes à balayage.

Un tel circuit est connu du brevet US-3544886. Ce document explique que l'impédance d'entrée des étages qui suivent le circuit déphaseur doit être importante, et le circuit de ce document comporte à cet effet un amplificateur adapté qui reprend le signal de sortie. En outre, le circuit décrit par ce document ne comporte pas de bornes de sortie pour retransmettre en sortie les signaux d'entrée. Ces signaux seraient néanmoins disponibles aux points référencés a et b sur les figures dudit document, mais le même problème se poserait à leur sujet concernant l'impédance d'entrée des étages qui suivent. En outre, si l'impédance d'entrée des étages qui suivent altère de façon similaire l'un et l'autre des deux signaux dits "de sortie", elle altèrerait de façon différente la phase et l'amplitude des signaux dits "d'entrée".

L'invention se propose de fournir un circuit déphaseur dont ni les amplitudes ni les phases relatives de tous les signaux utilisés en sortie ne soient altérées par l'impédance des étages qui suivent, pourvu que ces étages aient tous la même impédance.

A cet effet, le circuit selon l'invention comporte un premier circuit parallèle constitué d'une résistance et d'une capacité en parallèle, circuit parallèle qui est connecté entre la première borne d'entrée et une troisième borne de sortie, et un second circuit parallèle constitué d'une résistance et d'une capacité en parallèle, second circuit parallèle qui est connecté entre la seconde borne d'entrée et une quatrième borne de sortie.

Ainsi le circuit présente des bornes de sortie dont les phases et les amplitudes relatives, par rapport aux sorties des signaux déphasés, ne sont pas altérées même si les impédances des étages suivants sont modestes, car toutes les phases sont alors modifiées d'une même quantité, et il en est de même pour les amplitudes.

Afin d'obtenir que les valeurs des déphasages relatifs sur les quatre bornes de sorties soient respectivement égales à 0°, 180°, $\phi$, et $\phi$+180°, valeurs qui sont fréquemment souhaitées, les quatre résistances du circuit sont égales entre elles et les quatre condensateurs sont égaux entre eux, au moins en valeur nominale.

Chaque résistance est avantageusement ajustée pour compenser l'écart par rapport à la valeur nominale de la capacité qui lui est associée, afin d'obtenir le produit RC nécessaire.

Dans le cas où la fréquence des signaux est variable, soit les quatre résistances, soit les quatre capacités sont réglables ensemble au moyen d'une commande unique. Dans une version simplifiée avantageuse, soit les deux résistances, soit les deux capacités des combinaisons en série sont réglables ensemble au moyen d'une commande unique, et les éléments des circuits parallèles sont fixes.

La description qui va suivre, en regard des dessins annexés décrivant des exemples non limitatifs fera bien comprendre comment l'invention peut être réalisée.

La figure 1 est un schéma de circuit de l'art antérieur.

La figure 2 est un schéma de circuit selon l'invention.

Dans le cas particulier d'application à un récepteur BLU à réjection de fréquence image, un déphaseur est utilisé pour engendrer un signal de phase $\phi$ nécessaire à la réjection de fréquence image.

Certains montages nécessitent de disposer de quatre signaux avec les phases 0°, 90°, 180°, et 240°.

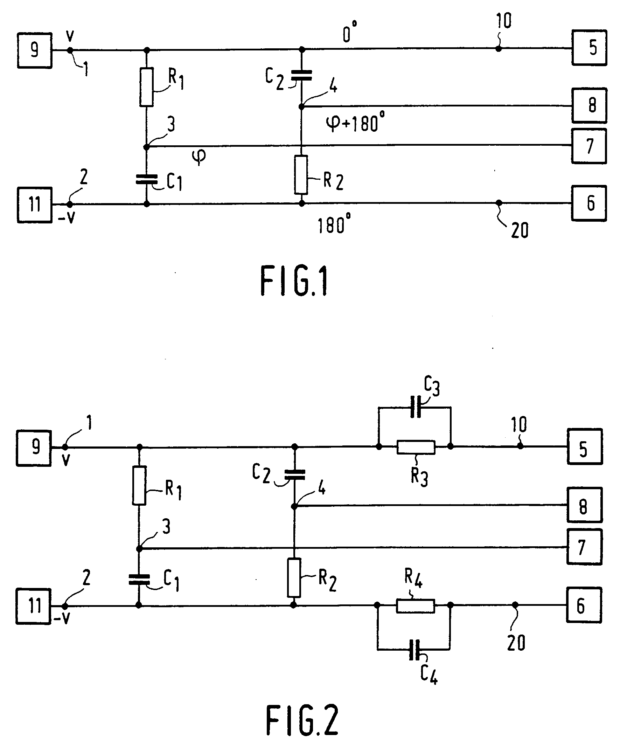

Le circuit déphaseur de la figure 1 est muni d'un circuit série $R_1$, $C_1$ d'impédance variable (par variation de $R_1$ ou $C_1$), alimenté en ses extrémités par des signaux v, -v en opposition de phase appliqués aux bornes d'entrée 1, 2. Un deuxième circuit $R_2$, $C_2$ "tête bêche" avec le premier permet d'obtenir la phase $\varphi$ + 180°. Un tel montage est fréquemment utilisé pour engendrer un signal d'amplitude constante et de phase variable $\varphi$.

Dans le cas de l'application à un récepteur pour modulation à bande latérale unique (BLU) à réjection de fréquence image, l'égalité d'amplitude des signaux 0 et 90° est aussi importante que la précision de phase pour obtenir une réjection élevée. Par exemple, avec 0,5dB d'écart d'amplitude, la réjection est limitée à 30dB. Dans ce domaine d'application (émetteur/récepteurs BLU), l'invention a donc un intérêt particulier.

Dans une telle application, on a besoin des quatre phases 0° et 180°, $\varphi$ et $\varphi$+180°. Le signal différentiel 0/180° est utilisé comme référence de phase pour le signal différentiel φ/φ+180°. On souhaite dans ce cas que tous les signaux soient d'égales amplitudes. Malheureusement les étages 5, 6, 7, 8 qui suivent et qui prélèvent ces signaux sur les bornes 3, 4, 10, 20 présentent des admittances d'entrée non nulles Yin = Gin + jωCin qui affectent les amplitudes relatives des signaux. En effet, le signal sur les sorties φ et φ + 180° (bornes 3, 4), est relié au signal 0/180° (bornes 10, 20) d'amplitude v par la relation

$$N_\varphi = \pm \frac{G - j\omega C}{(G + Gin) + j\omega(C + Cin)} v$$

Le signal est donc atténué sur les sorties φ et φ + 180° car le module de la fonction de transfert est inférieur à 1. Pour ramener cette atténuation à une valeur raisonnable (≦1dB) il faut que G≧10Gin et C≧10Cin ce qui nécessite l'emploi d'un étage très haute impédance et/ou d'un circuit RC de faible impédance. Cependant, l'impédance du circuit RC doit aussi être grande devant l'impédance de sortie des étages 9, 11 qui engendrent les signaux v, -v(0,180°) de référence, si l'on désire que l'amplitude des signaux varie peu avec la fréquence et/ou la phase φ. On a donc le compromis suivant à réaliser :

$$Zout << R + \frac{1}{j\omega C} << Zin$$

où Zout est l'impédance de sortie des étages 9, 11 et Zin est l'impédance d'entrée des étages 5-8.

Ce compromis est très contraignant et le circuit selon l'invention permet de s'affranchir de la nécessité d'un étage de charge à haute impédance d'entrée pour préserver l'égalité d'amplitude des signaux.

Dans ce circuit représenté par la figure 2, un circuit RC parallèle $R_3$, $C_3$ ou $R_4$, $C_4$ est ajouté au circuit précédent, en série dans chacune des voies 0° et 180°, c'est-à-dire entre les bornes d'entrée 1, 2 toujours reliées aux deux circuits série $R_1$, $C_1$ et $R_2$, $C_2$, et les bornes de sortie 10, 20.

La résistance et la capacité de ces circuits parallèles $R_3C_3$ et $R_4C_4$ sont de même valeur que dans les circuits déphaseurs série $R_1C_1$ et $R_2C_2$. Par rapport au signal différentiel d'entrée d'amplitude v, le signal de sortie 0/180° (bornes 10,20) est donné par :

$$v_{0°/180°} = \pm \frac{G + j\omega C}{(G + Gin) + j\omega(C + Cin)}$$

et le signal de sortie φ/φ+180° (bornes 3,4) est donné par :

$$V_{\varphi/\varphi + 180°} = \pm \frac{G - j\omega C}{(G + Gin) + j\omega(C + Cin)}$$

L'amplitude sur les quatre bornes de sortie 3, 4, 10, 20 est identique quels que soient la fréquence, le déphasage apporté par les circuits RC, et l'impédance d'entrée des étages de charge 5-8.

On a donc réalisé une compensation quasi parfaite qui ne nécessite plus à tout prix l'utilisation d'un étage de charge à haute impédance. L'effet de l'impédance de charge est seulement d'atténuer identiquement les quatre signaux de sortie du système, à condition, bien entendu, que les impédances, si elles ne sont pas élevées, soient par contre égales entre elles, au moins en valeur nominale. Le taux de réjection qui peut être obtenu dans le récepteur BLU dépend des tolérances admises sur tous les composants.

Dans le cas particulier où un tel circuit serait utilisé pour obtenir un déphasage fixe à fréquence fixe, il serait avantageusement réalisé dans la technologie des circuits dits hybrides, comportant sur un même substrat des résistances intégrées et des condensateurs rapportés. La valeur de chaque résistance peut ainsi être ajustée (par exemple au moyen d'un laser) en fonction de la capacité qui lui est accouplée, compensant ainsi l'erreur possible sur la valeur nominale de cette dernière.

Lorsqu'au contraire la fréquence varie, ou bien le déphasage désiré, il faut pouvoir faire varier soit R, soit C. La méthode préférée consiste à faire varier ensemble au moyen d'une commande unique soit les quatre résistances, soit les quatre capacités, ceci de façon à conserver tous les produits RC égaux entre eux.

En pratique, on peut aussi obtenir un compromis intéressant en choisissant pour $R_3$, $C_3$, $R_4$, $C_4$ des valeurs fixes, correspondant à peu près à la valeur nécessaire au milieu de la gamme de fréquence ou de la gamme de variation de φ, et en faisant varier, au moyen d'une commande unique, seulement $R_1$ et $R_2$, ou $C_1$ et $C_2$.

Dans l'application particulière à un récepteur BLU pour des fréquences de l'ordre de 1 à 5 GHz, les étages 5 à 8, 9, 11 sont réalisés au moyen de transistors MESFET sur un substrat en arséniure de gallium. Les résistances R1 à R4 sont constituées chacune par un transistor MESFET utilisé en résistance variable. Ces transistors ont tous la même dimension et sont commandés ensemble par une tension de polarisation de grille commune variable destinée à faire varier à volonté leur résistance dynamique. Pour les fréquences indiquées, les transistors peuvent avoir par exemple une largeur de grille d'environ 10μm, et les capacités (intégrées) ont une valeur de 0,1 pF. Dans les étages de sortie 5 à 6, l'entrée du signal se fait sur la grille d'un transistors MESFET.

Dans une application à fréquence plus basse, on pourrait aussi utiliser des capacités variables, par exemple réalisées au moyen de diodes à capacité variable, toutes commandées par une même tension de polarisation, les résistances étant alors fixes.

## Revendications

1. Circuit déphaseur, muni d'une première et d'une seconde borne d'entrée destinées à recevoir deux signaux en opposition de phase, et d'une première et d'une seconde borne de sortie destinées à fournir deux signaux déphasés par rapport aux signaux d'entrée, circuit comportant une première combinaison en série d'une résistance et d'une capacité connectées entre les bornes d'entrée, première combinaison dans laquelle la résistance est connectée à la première borne d'entrée et le point de jonction entre la résistance et la capacité est relié à la première borne de sortie, et une seconde combinaison en série d'une résistance et d'une capacité connectées entre les bornes d'entrée, seconde combinaison dans laquelle la résistance est connectée à la seconde borne d'entrée et le point de jonction entre la résistance et la capacité est relié à la seconde borne de sortie, caractérisé en ce qu'il comporte un premier circuit parallèle constitué d'une résistance et d'une capacité en parallèle, circuit parallèle qui est connecté entre la première borne d'entrée et une troisième borne de sortie, et un second circuit parallèle constitué d'une résistance et d'une capacité en parallèle, second circuit parallèle qui est connecté entre la seconde borne d'entrée et une quatrième borne de sortie.

2. Dispositif selon la revendication 1, caractérisé en ce que, en valeur nominale, les quatre résistances sont égales entre elles et les quatre condensateurs sont égaux entre eux.

3. Dispositif selon la revendication 2, caractérisé en ce que chaque résistance est ajustée pour compenser l'écart par rapport à la valeur nominale de la capacité qui lui est associée, afin d'obtenir le produit RC nécessaire.

4. Dispositif selon l'une des revendications 1 ou 2, utilisé dans le cas où la fréquence des signaux est variable, caractérisé en ce que soit les quatre résistances, soit les quatre capacités, sont réglables ensemble au moyen d'une commande unique.

5. Dispositif selon l'une des revendications 1 ou 2, utilisé dans le cas où la fréquence des signaux est variable, caractérisé en ce que dans les combinaisons en série, soit les deux résistances, soit les deux capacités, sont réglables ensemble au moyen d'une commande unique, et les éléments des circuits parallèles sont fixes.

**Patentansprüche**

1. Phasenschieber mit einer ersten und einer zweiten Eingangsklemme zum Empfangen von zwei gegenphasigen Signalen und mit einer ersten und einer zweiten Ausgangsklemme zum Liefern von zwei gegen die Eingangssignale phasenverschobenen Signalen sowie mit einer ersten Reihenschaltung aus einem Widerstand und einer Kapazität, die zwischen den Eingangsklemmen geschaltet sind, wobei in der ersten Reihenschaltung der Widerstand mit der ersten Eingangsklemme verbunden und der Verbindungspunkt zwischen dem Widerstand und der Kapazität an die erste Ausgangsklemme angeschlossen ist, und mit einer zweiten Reihenschaltung aus einem Widerstand und einer Kapazität, die zwischen den Eingangsklemmen geschaltet sind, wobei in der zweiten Reihenschaltung der Widerstand mit der zweiten Eingangsklemme verbunden und der Verbindungspunkt des Widerstands und der Kapazität an die zweite Ausgangsklemme angeschlossen ist,
dadurch gekennzeichnet, daß der Schieber einen ersten Parallelkreis aus einem Widerstand und einer Kapazität in Parallelschaltung, wobei dieser Parallelkreis zwischen der ersten Eingangsklemme und einer dritten Ausgangsklemme angeschlossen ist, und einen zweiten Parallelkreis aus einem Widerstand und einer Kapazität in Parallelschaltung enthält, wobei der zweite Parallelkreis zwischen der zweiten Eingangsklemme und einer vierten Ausgangsklemme angeschlossen ist.

2. Phasenschieber nach Anspruch 1,
dadurch gekennzeichnet, daß hinsichtlich des Nennwerts die vier Widerstände untereinander und die vier Kondensatoren untereinander gleich sind.

3. Phasenschieber nach Anspruch 2,
dadurch gekennzeichnet, daß jeder Widerstand zum Ausgleichen der Abweichung vom Nennwert der ihm zugeordneten Kapazität eingestellt ist, um das erforderliche RC-Produkt zu erhalten.

4. Phasenschieber nach einem der Ansprüche 1 oder 2 in der Verwendung, wenn die Frequenz der Signale variabel ist, dadurch gekennzeichnet, daß entweder die vier Widerstände oder die vier Kapazitäten mittels eines einheitlichen Befehls zusammen regelbar sind.

5. Phasenschieber nach einem der Ansprüche 1 oder 2 in der Verwendung, wenn die Frequenz der Signale variabel ist, dadurch gekennzeichnet, daß in den Reihenschaltungen die zwei Widerstände oder die zwei Kapazitäten mittels eines einheitlichen Befehls zusammen regelbar sind und die Bauteile der Parallelkreise feste Werte haben.

**Claims**

1. A phase shifter arrangement having a first and a second input terminal intended for receiving two signals in phase opposition, and having a first and a second output terminal intended for supplying two signals which are shifted in phase relative to the input signals, the arrangement comprising a first series circuit of a resistor and a capacitor connected between the input terminals, in which first series circuit the resistor is connected to the first input terminal and the junction point between the resistor and the capacitor is connected to the first output terminal, and comprising a second series circuit of a resistor and a capacitor connected between the input terminals, in which second series circuit the resistor is connected to the second input terminal and the junction point between the resistor and the capacitor is connected to the second output terminal, characterised in that it comprises a first parallel circuit constituted by a resistor and capacitor in parallel, which first parallel circuit is connected between the first input terminal and a third output terminal, and a second parallel circuit constituted by a resistor and capacitor in parallel, which second parallel circuit is connected between the second input terminal and a fourth output terminal.

2. An arrangement as claimed in Claim 1, characterised in that the four resistors are equal to one another and the four capacitors are equal to one another, at least in nominal value.

3. An arrangement as claimed in Claim 2, characterised in that each resistor is adjusted to compensate for the difference with respect to the nominal value of its associated capacitor, in order to obtain the required RC product.

4. An arrangement as claimed in Claim 1 or 2, used in the case that the frequency of the signals is variable, characterised in that either the four resistors or the four capacitors are adjustable together by means of a single control.

5. An arrangement as claimed in Claim 1 or 2, used in the case that the frequency of the signals is variable, characterised in that either the two resistors or the two capacitors of the series circuits are adjustable together by means of a single control, and the elements of the parallel circuits are fixed.

EP 0 401 906 B1

FIG.1

FIG.2

5